(19) Europäisches Patentamt
European Patent Office
Office européen des brevets

(11) **EP 2 731 210 A1**

(12) **EUROPEAN PATENT APPLICATION**
published in accordance with Art. 153(4) EPC

(43) Date of publication:
**14.05.2014 Bulletin 2014/20**

(21) Application number: **12808194.0**

(22) Date of filing: **28.06.2012**

(51) Int Cl.:
*H01S 5/026* [(2006.01)]   *H01L 31/04* [(2014.01)]
*F24J 2/07* [(2006.01)]   *G02B 6/42* [(2006.01)]

(86) International application number:
**PCT/ES2012/070480**

(87) International publication number:
**WO 2013/004870 (10.01.2013 Gazette 2013/02)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **05.07.2011 ES 201131142 P**

(71) Applicant: **Abengoa Solar New Technologies, S.A.
41014 Sevilla (ES)**

(72) Inventors:
• **NUÑEZ BOOTELLO, Juan Pablo
  E-41014 Sevilla (ES)**
• **GALLAS TORREIRA, Manuel
  E-41014 Sevilla (ES)**

(74) Representative: **Elzaburu S.L.P.
C/ Miguel Angel, 21
28010 Madrid (ES)**

(54) **SOLAR PLANT**

(57)     The invention enables the transformation of solar energy using the majority of the solar spectrum with a very efficient yield. The invention comprises at least one solar collector (11) that comprises a focal point and is suitable for collecting solar radiation and concentrating it in the focal point; a solar laser device (10) for transforming the radiation received from the focal points into laser radiation; and a receiver (1) and/or a solar reactor (21) suitable for receiving the radiation from the laser device (10) and transforming it into another type of energy. The invention can comprise flexible light guides (8) or flat mirrors (26) for transporting the radiation received from the laser device to the solar reactor (21) and/or the receiver (1). It can also comprise photovoltaic cells (18) inserted between the collectors and the laser devices for transforming the concentrated radiation of the focal points into electricity and letting through the radiation that they do not transform to the laser devices.

FIG. 5

EP 2 731 210 A1

## Description

## PURPOSE OF THE INVENTION

The present invention may be included within the field of solar technology. The purpose of the invention pertains to a solar plant which enables the transformation a larger portion of incoming solar radiation spectrum into electrical or thermal energy.

## BACKGROUND OF THE INVENTION

The exploitation of solar energy poses a number of challenges. One of them is the capture and concentration of that solar energy, an issue that is widely researched, developed and applied today. In this respect, the challenge of solar plants is: to maximise the $C/C_{max}$ ratio of concentrator collectors (where C is the concentration and $C_{max}$ = 1 /sine (half acceptance) is the theoretical maximum concentration), to minimise geometric losses - cosine effect, shadows and blockages among trackers -, optical and heat losses, and to lower the plant costs at levels that make the technology competitive in relation to other energy sources. Importantly, maximising concentration allows us to reduce heat losses in the plant, reduce the cost of receiving devices (typically solar thermal or photovoltaic) and/or increase the typical working temperatures of the heat transfer fluids or reactors for obtaining solar fuels.

Another major challenge is the transformation of solar energy into electrical energy. Currently there are two main commercial avenues:

> 1- Photovoltaic technology: involves converting solar electromagnetic radiation directly into electricity through semiconductor materials using photovoltaic cells. It is a constantly evolving technology that has the potential to improve sufficiently so as to surpass the efficiency of solar thermal power plants, thanks to the future use of advanced materials. However, it has the disadvantage of being unmanageable, and a wavelength range exists above which photovoltaic cells are not capable of converting all the energy from photons into electrical energy, and below which the excess of energy transported by the photon is lost as heat.

> 2- Solar thermal technology: involves heating a heat transfer fluid and generating electricity in a turbine via a Rankine cycle, Brayton cycle, Stirling engine or others, or else causing a reaction to obtain hydrogen directly from water at temperatures up to 2000 °C using third substances (Zinc and others) or alternative processes (S-I Sulfur Iodine cycle); ammonia from nitrogen and hydrogen; any other solar fuel. This is also a technology that is constantly evolving. It does not present the disadvantage mentioned above in relation to photovoltaic technology, but it has other problems discussed below. It is currently anticipated that tower type central receiver plants will allow, in the medium term, the improvement both in efficiency and in cost of other commercial technologies in the market for large electricity production plants on the order of tens or a few hundred MW. However, central receiver plants suffer from the so-called cosine effect (effect of decreasing effective reflecting area of the mirror due to the angle formed by the rays relative to the normal for said reflecting surface), spillover in the receiver, losses from transmittance and other phenomena that limit their efficiency when compared to the potential of photovoltaic technology.

In terms of distributed or market generation in the tens of kW, Stirling dishes are a solution under development that is still expensive but look promising. One of the issues that makes this technology so expensive is its having to support a heavy cantilever engine at the centre of the concentrator.

In its favour compared to photovoltaics, solar thermal technology has thermal inertia, the ability to hybridise and the ability to store heat.

The limitations of thermosolar receiver plants can be salvaged using lightguides to transport the concentrated light. Guiding concentrated sunlight with minimal losses from the catchment area to the processing area is another big challenge. Moreover, the challenge is twofold: on one hand to develop lightguides with materials capable of transmitting the full spectral width of sunlight, and the other to use lightguides that are compatible with advanced collectors (non-imaging optics) and allow high concentrations, that is, lightguides of a high numerical aperture.

Examples of lightguides are traditional fibre-optics, liquid lightguides and photonic crystal fibres (PCFs).

The traditional fibre-optic lightguides - see document "Solar fibre-optic mini-dish concentrators: First experimental results and field experience" (D. Feuermann, J. M. Gordon, M Huleihil) - April 2002" - have only a limited numerical aperture (maximum 0.48) which restricts the potential light absorption and the concentration levels of the solar collectors. Additionally, these guides do not allow for efficient guiding of the solar spectrum over distances of tens of meters. Losses in the fibre-optic lightguides are caused by three mechanisms: Rayleigh type scattering, absorption due to metallic impurities and water inside the fibre, and intrinsic absorption by the molecule of the fibre-optic material itself, silica. The confluence of these three mechanisms limit the window of the solar spectrum that can be guided through the fibres without losses to from 1000 - 1250 nm up to an upper limit of 1650 nm, showing a loss of 0.2 dB/km around 1550 nm. The conclusion is that, in the best case, these fibres do not efficiently transmit a significant portion of the solar spectrum (UV, visible and part of the near-IR) representing over 40% of the accumulated energy in the solar spectrum.

In regards to the Rayleigh scattering mechanism: this is the result of elastic collisions between the electromagnetic wave and silicon molecules inside the fibre. If the scattered light is maintained within the numerical aperture of the fibre, it continues its journey through total internal reflection inside the fibre and no attenuation occurs. Thus, to increase the numerical aperture of the fibre helps reduce losses from Rayleigh scattering and increase the spectrum window.

As for absorption losses due to impurities: there are currently manufacturing methods such as MCVD type (modified chemical vapour deposition) or OVD (outside vapour deposition), which allow the manufacture of fibres without impurities or with a very small concentration of impurities. These manufacturing methods allow maintaining loss levels in dB/km sufficiently low at all wavelengths of the above mentioned window.

As for the mechanism of intrinsic absorption due to the fibre material itself: there is progress in the development of new materials for fabricating the fibres to increase this window. One example is ZBLAN glass fibre and GaLaS. ZBLAN glass (composed of zirconium, barium, lanthanum, aluminium and sodium fluorides) has acceptable yields for wavelengths between 250 and 4000 nm, with a loss of 0.05 dB/km at 2550 nm. Galas glass, also referred to as GLS which comprises $Ga_2S_3$ and/or $La_2S_3$ has a region of transparency of wavelengths of 500 nm to 10000 nm and a loss of 0.5 dB/km at around 3500 nm.

Since the early 90s, development has been underway on photonic crystal fibres (PCFs onwards). Photonic crystal fibres are silica fibres with a central core (sometimes hollow) surrounded by a periodic structure of holes filled with air. Photonic crystals possess a periodic modulation of the refractive index, their period being on the order of the wavelength of the electromagnetic field in the optical range.

There are, among others, two types of PCFs: the IGF type ("Index Guiding Fibres") and PBF type ("Guiding Bandgap Fibres").

It is important to note that PCFs are revolutionizing the world of photonics and data transmission in telecommunications. The unusual light guiding mechanism in PCFs lends them a number of unique properties that distinguish them from conventional fibres. For instance, it is possible to build them with very small cores (diameters up to 1 micron) to enhance nonlinear effects, to build with very high numerical apertures, or with very broad single-mode propagation bands. Moreover, the chromatic scattering of these fibres can be flexibly adjusted by design adapted to their geometry, making obtainable values that are unattainable using conventional fibre optic technology. In this respect, some institutions have managed to develop PCFs made of $P_2O_5$-dope silica with losses up to 0.095 dB/km at 1550 nm. In addition, they have managed to successfully achieve transmission speeds of 640 Gbit/s.

PCFs can also be used to guide sunlight. In this case, not only the material composition, but the geometry of the air nanotubes and the width of the bridges between them allow control of the modal properties and the increase of the numerical aperture and absorption of more sunlight for the same diameter and the same length of fibre. The application of sunlight guiding carries highly targeted specifications: high numerical apertures (0.9), maximization of the fibre diameter and transmission potential and minimization of losses in dB/km.

Currently in continuous development are so-called multi-junction photovoltaic cells, which are capable of absorbing a portion of the spectrum with high efficiency, increasingly as more layers are contained. Thus, triple junction cells consisting of InGaAs, Ge and InGaP semiconductors have current efficiencies on the order of 39%, but there are wavelength ranges in which it is not capable of converting photons into electrical energy.

Photovoltaic technology has its elevated efficiency in its favour against thermosolar.

From the above, it follows that the advanced lightguides being developed at present make it possible to achieve numerical apertures on the order of 0.9. However, they have the downside of being manufactured from materials incapable of transmitting the full spectral width of the sun with losses - in dB/km - to make this technology feasible. The window of solar spectrum that can be guided with satisfactory losses, ranges from 1000 nm - 1250 nm to an upper limit of 1650 nm, showing a loss of 0.2 dB/km at around 1550 nm.

Today, advances are also being made in the investigation of elements capable of transforming solar radiation (into electricity or thermal energy) with maximised yields across the spectral width (ultraviolet, visible and near infrared). In particular, progress is being made in concepts based on "photon management," which seeks to separate or modify the solar spectrum before the photons are absorbed by photovoltaic solar cells.

In these cases, wavelength converters are used, specifically converters to low wavelengths (so-called "down converters") and high wavelengths (so-called "up converters"), that allow the transformation of ultraviolet and/or visible radiation ranges into infrared radiation, and infrared into visible and/or ultraviolet radiation. There are some state of the art examples of such converters, but they do not allow for achieving high enough efficiencies or maintaining high optical concentrations, mainly due to the direction of the light emitted after the conversion- it has no preferred direction or directions.

Otherwise, there are solar laser devices known that can convert a portion of the sunlight spectrum into a laser beam. Solar laser devices possess the following elements:

- An optical cavity, resonator or optical oscillator comprising two mirrors wherein the laser light is trapped bouncing between them. To simplify, one may say that the resonator only allows resonance frequencies in proportion to c/2L (where c is the speed of light and L is the optical path of the light beam) and their associated modes;

- A doped active medium, which may be solid, liquid or gaseous, and whose function is to amplify a specific range of wavelengths as the photons undergo multiple reflections within the cavity and pass through it; and

- A source of sunlight capable of generating the inversion of the population in the active medium. In other words, light capable of causing that in said medium, more atoms are in an excited state (atom at a higher level of quantum mechanical energy) than at a lower energy state, whereby many of the atoms in the system would emit light in a so-called stimulated condition.

Both the resonator and the active medium of the solar laser are preferably cylindrical, and at their ends are located two separate reflective mirrors The solar laser devices found in the literature are laterally illuminated by sunlight concentrated via CPC type (Compound Parabolic Concentrator) concentrators. The first reflecting mirror of the cavity is adapted to be highly reflective at the laser oscillation wavelength and around it. This mirror has high reflectivity only in this area. The other mirror at the laser output partially reflects (R2) the resulting light, and transmits (T2) the fraction that does not reflect: T2 = 1- R2. This transmitted light is, itself, the laser light that exits the device. Thus, photons are trapped in the resonator, moving from one mirror to another and being amplified by the active medium. Exiting the laser device is the fraction of laser light that the exit mirror allows, as a function of transmittance at the laser oscillation wavelength.

The solar laser, therefore, has a cavity between the two mirrors that favours reflection of the photons that are reflected alternately in each of the mirrors and are amplified after each pass through the active medium. If amplification is high enough to overcome the losses, which is commonly called threshold condition, a single photon can be amplified by several orders of magnitude to produce a very large number of coherent photons trapped within the resonator. If the photons shuttle between the mirrors for a long enough period of time, the laser will reach a steady state.

The pumping of solar energy to the laser can be produced both from the lateral side thereof and longitudinally thereto, that is, from one end, so that light is injected in the direction of the laser beam generated.

The solar laser can transform a portion of the incoming solar spectrum into an outgoing laser beam at a specific wavelength. The laser beam can supply a PCF conveyed by the laser itself. The substance of the active medium has an absorption spectrum that does not have to match its emission spectrum. The laser may thus be pumped with light of a different wavelength range from the one at which it is emitting.

Also known at the technological forefront are double-clad PCF laser devices, in which the active medium is made by doping the core of the PCF fibre. The first coating has an index of refraction slightly lower than the core and is designed to guide in single mode the laser radiation generated inside the core, while the second coating contains microstructure comprised of air tubes separated by a distance typical in terms of classic PCF and with D-shaped or other cross section. This type of PCF allows very high numerical apertures.

From the above it follows that the efficiency of transforming solar energy to electricity, and the manageability, with the current media is demonstrably improvable and, moreover, it is possible to exploit the width of the solar spectrum (ultraviolet, visible and near infrared) more efficiently.

The invention covered by this patent aims to develop hybrid photovoltaic-thermosolar plants with a series of features that allow, first, the use of photovoltaic technology to transform with high efficiency a portion of the solar spectrum into electricity and, second, the use of thermosolar technology under the principle of light guiding in order to harness the remainder of the spectrum.

## DESCRIPTION OF THE INVENTION

This invention solves the technical problem posed through a solar plant that allows for maximised exploitation of solar radiation. The solar plant of the invention comprises the following elements:

- At least one solar collector equipped with a concentrator, said solar collector adapted to collect solar radiation and concentrate that solar radiation in the concentrator;

- At least one solar laser device, as a solar converter, where the laser device is adapted to receive (directly or indirectly) concentrated radiation from the concentrators in the collectors and transform said concentrated radiation into laser radiation, and

- A receiver adapted to receive radiation from the laser and transform it into thermal energy (heating a heat transfer fluid) or directly into electricity using the photoelectric effect; and/or a solar reactor adapted to obtain solar fuel, for instance hydrogen directly from water at temperatures up to 2000 °C by use of third substances (zinc or others), or from alternative processes (S-I sulfur iodine); ammonia from nitrogen and hydrogen; or any other solar fuel.

As explained below, the laser device may receive radiation directly from the concentrators of the collector, or the installation may incorporate a photovoltaic cell that receives the concentrated radiation from the concentrators of the collector, in such a manner that it transforms a portion of said radiation into electric energy, and is transparent to the part it does not transform, allowing that part it does not transform to pass into the laser device.

The invention's solar plant is notable because by inserting a laser device between the collector and receiver, it guaranteed the transformation of almost all the radiation that is collected by the collectors. Additionally, as is known, a light beam always has divergence due to the phenomenon of scattering. A beam emitted by a D-diameter laser device (a laser beam) has the characteristic of reaching the minimum theoretical half divergence imposed by diffraction (diffraction limited beam), which is of the order of $\lambda/D$, where $\lambda$ is the operating wavelength of the laser device.

This means that laser devices reach the theoretical limit of collimation. This is in itself an advantage of the use of energy from solar-pumped laser devices because the laser beam can be conducted to a receiver, both inside lightguides (as explained below) and directly through the atmosphere by the use of plane mirrors. Thus, when the distance between the laser device and the receiver allows, the greatly reduced losses from laser beam divergence allow the beam to be directed at the receiver using simple reflection in plane mirrors.

The solar collectors can be of any known type, both traditional (paraboloid type disc collectors, Fresnel lens type collectors) and advanced type collectors, created with (non image-forming) non-imaging optics.

Similarly, the collectors are preferably linked to a few two-axis solar trackers pointed at the sun without cosine effect, so that each solar collector can either have its individual solar tracking device, or there can be at least one tracking device linked to a corresponding heliostat, onto which are mounted a number of collectors.

In case the receiver is not close enough to the laser devices, it is advantageous to direct the laser beam toward the receiver via plane mirrors, and it is anticipated that the invention will additionally incorporate flexible lightguides that receive the laser beams and transmit them to the receiver.

The lightguides used may be of any of the many different existing types and technologies.

In particular, taking into account the manufacturing technology, as an example, the following types of lightguides can be used:

- traditional fibre optic guides,
- PCF type guides,
- liquid lightguides (LLG).

In particular, taking into account the materials used, as an example, the following types of lightguides can be used:

- silica lightguides;
- ZBLAN glass lightguides;
- GaLaS glass lightguides;

The numerical aperture of the guides is preferably compatible, at least partially, with the aperture of the photovoltaic cell, the laser and solar collectors.

The invention additionally may include lenses for multiplexing the radiation contained in guides, or reconcentrating the laser beams if they are directly transmitted through the atmosphere in order to optimise the incident radiation on the receiver. In the first case, the lightguides may be divided into several groups, and each of these groups being multiplexed into a combined guide.

The invention additionally may incorporate reconcentrators just before receiver for the same purpose of optimizing the incident radiation thereon.

Optionally, the lightguides can be advantageously directed to the receiver so that the lightguides whose first ends are arranged in adjacent locations do not affect adjacent receptor locations. Thus, the incident radiation on a particular area of the receiver does not come from a single area of collectors, thereby offsetting the effects of some collectors being periodically in the shade, and obtaining a uniform incidence on the receiver tubes. What is explained above can be implemented both in the case that the lightguides are directed directly at the receiver, as in the case that lenses are arranged to multiplex the lightguides into combined guides, according to at least one of the selected options in the following non-exhaustive list:

- lightguides of a single area of collectors are multiplexed into combined guides, and these combined guides corresponding to adjacent areas in turn have incidence on different areas of the receiver; and
- the combined guides comprise lightguides from different areas of collectors.

As for the receiver, this invention is applicable for any type of receiver compatible with the use of concentration collectors and, if necessary, lightguides.

In particular, tubes receivers arranged vertically are preferred, through which a heat transfer fluid is circulated.

Thus, the tubes of the receiver can be arranged in one or several rows, preferably in more than one row overlapping the tubes so the radiation will always find one of the tubes. Additionally, tubes may be or may not enclosed in housings under vacuum, with individual or common housings for multiple tubes. Moreover, the tubes may be equipped with antireflection coatings.

Preferably, the guides cause radiation to be received at the tubes normally on the surface of said tubes, preferably from two opposing directions to avoid thermal stress in the tubes.

Since the direct conversion of solar radiation into electric energy through photovoltaic cells has a potential for higher efficiency than transformation via a heat transfer fluid, the invention plant may further include at least one photovoltaic cell (preferably a plurality), arranged on the collector concentrators, and interspersed among collectors and laser devices to transform a part of the solar spectrum into electric energy, where said photovoltaic cells are transparent to the solar radiation that does not get converted, allowing said radiation to pass to the laser device. Thus, photovoltaic cells may be used to more efficiently obtain electrical energy to supply some of the system devices, such as lasers or, where appropriate, other types of system consumption or even for sale to the grid.

The invention allows the use of photovoltaic cells of varying technologies, although for each particular plant, performance is optimal if the components - collectors, guides, photovoltaic cells, laser device(s) - are selected rationally according to the conditions of the plant and of the optical characteristics of the elements.

In any case, so-called HCPV cells are preferred (High Concentration Photovoltaic Cells), particularly in this type, multi-junction cells.

When using flexible lightguides, the laser device is adapted to concentrate, directly or through photovoltaic cell, the radiation from the collector concentrators into a laser beam with a wave length compatible with the optimum operating range of the lightguides.

As has just been explained, a portion of solar radiation is transformed into electric energy by the photovoltaic cell, another part is transformed by the laser device for the lightguide to route to a thermosolar or photovoltaic receiver, for an end result of achieving optimal use of the solar spectrum.

The invention is adapted for any type of laser, although the plant needs will inform the use of a specific laser for each case, depending also, among other things, on the optical characteristics of the remaining elements (collectors, guides, photovoltaic cells).

A laser device typically comprises a resonator, an amplifier with a doped active medium, and a light source capable of generating population inversion in the active medium.

In particular, laser devices may be used with doped active liquid, gaseous or solid media (including semiconductors), and laser devices may be used with both lateral and longitudinal pumping, the latter being preferable as it ensures:

- a higher efficiency of sunlight to laser light conversion;
- a high-quality laser beam that would exit in TEM00 fundamental transverse mode with the maximum theoretical degree of collimation (diffraction limited beam quality), if the perimeter of the concentrated solar light is kept within the volume of the fundamental resonator mode (at least within the perimeter of the glass of the laser device). The maximum degree of collimation is approximately the wavelength of the laser output divided by the typical mode diameter.

Consistent with all the embodiments described, the invention plant may further include storage means for accumulating energy.

The storage means are related to other elements of the system: thus, for example, the storage means may comprise at least one of the following:

- electric accumulators for accumulating electrical energy delivered by photovoltaic cells;
- tanks of hot air/gas, if the heat transfer fluid in the receiver tubes is air or gas fed to a gas turbine based on a Brayton cycle;
- tanks of compressed saturated steam, if the heat carrying fluid in the receiver tubes is water fed to a steam turbine based on a Rankine cycle, or if the heat transfer fluid is a liquid salt which heats water through an exchanger for the same purpose;
- salts at high temperature (in the case of Rankine cycle with salt).

Consistent with all embodiments described that contain a receiver, the invention plant may include a steam turbine, a gas turbine, a Stirling engine, a micro turbine, AMTEC element (Alkali-metal thermal to electric converter), or multi-junction, single-junction, organic or inorganic type photovoltaic cells.

As explained above, the invention solar plant makes it possible to transform solar energy into electricity with greater yields than current solar energy plants in a manageable way, and efficiently exploiting the width of the solar spectrum (ultraviolet, visible and the near infrared).

## DESCRIPTION OF THE DRAWINGS

To supplement the description given here, and for purposes of fostering a better understanding of the characteristics of the invention, based on recommended models for the practical application thereof, as an integral part of the description, a set of drawings is attached whose representation includes, but is not limited to, the following:

Figures 1a and 1b -. Show a comparison between the respective divergence of a beam emitted in a lens-type concentrator device, and a beam emitted by a laser-type concentrator device.

Figure 2 -. Shows a diagram of operation of the first embodiment of the invention.

Figure 3 -. Shows a diagram of operation of the second embodiment of the invention.

Figure 4 -. Shows a diagram of operation of the third embodiment of the invention.

Figure 5 -. Shows a top view of the invention plant, according to the third embodiment.

Figure 6: Shows a top view in detail of part of the invention plant according to the first embodiment.

## PREFERRED EMBODIMENTS OF THE INVENTION

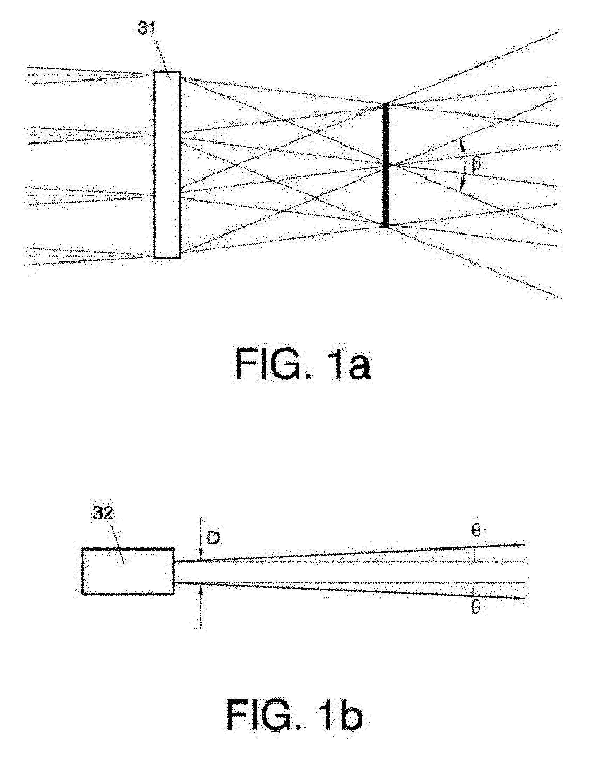

Following is a description of three recommended models of the invention, with the aid of Figures 1 to 6 attached.

FIRST PREFERRED EMBODIMENT

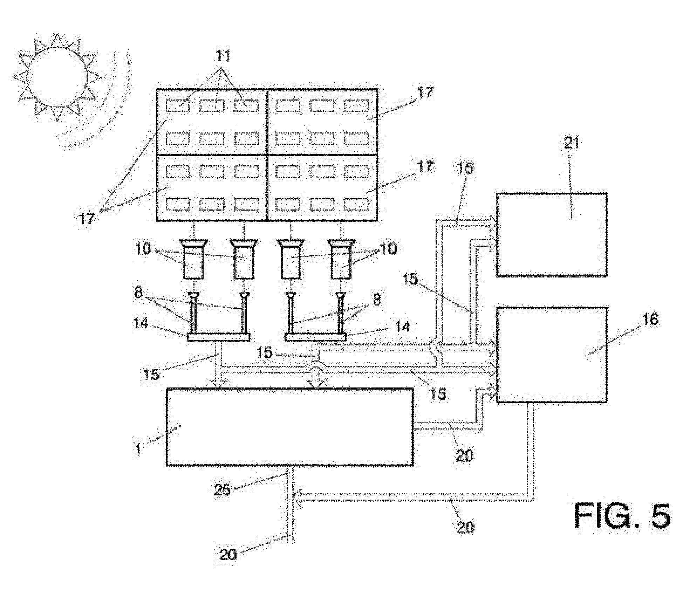

The invention, as shown in the accompanying figures, refers to a solar plant to obtain energy (20) (see Figure 5) from solar radiation with an optimum use of the solar spectrum.

As seen in Figure 1a, the resulting light beam of a first lens type concentrator device (31) has some divergence. The divergence associated with these first concentrator devices (31) is linked to the concentration achieved. The greater the concentration attempted, the greater the divergence of the output beam. This phenomenon is explained by the Etendue conservation theorem. In three-dimensional systems.

$$n^2 \cdot A \cdot sen^2\left(\frac{\beta}{2}\right) = cte \text{ , where n is the refractive}$$

index of the medium, A is the area of the element belonging to the first concentration device (31), where concentration takes place, and $\beta$ the angle of divergence of the rays leaving the lens.

For the case of a second laser type concentrator device (32), as shown in Figure 1b, the half angle of divergence is $\theta = \lambda/D$, where $\lambda$ is the wavelength of the laser beam emitted by the laser device (32) and D is the diameter of the laser beam.

It is found that the value of the half angle of divergence $\theta$ is significantly smaller than $\beta/2$.

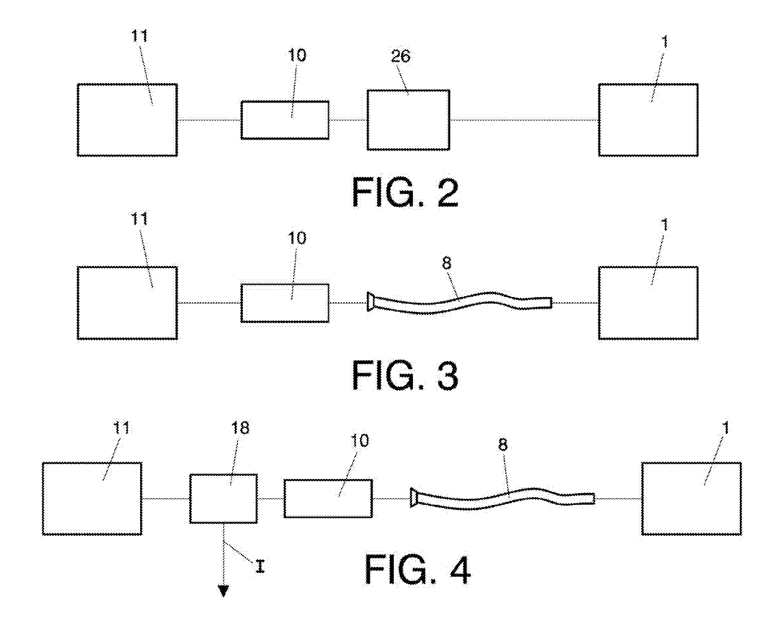

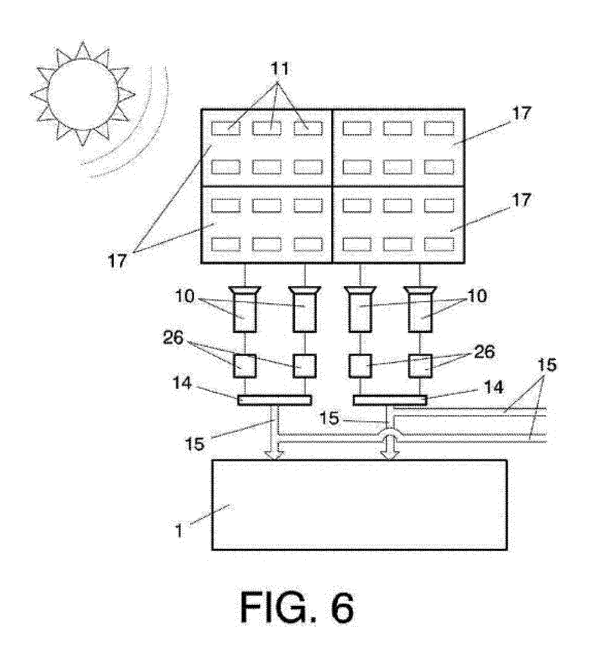

The solar plant, in a first recommended model of the invention, comprises the following elements, as shown in Figures 2 and 6:

- multiple solar collectors (11) equipped with two separate concentrators (not shown), and solar tracking devices (not shown) in two axes, said solar collectors (11) adapted to collect solar radiation and concentrate the solar radiation in its corresponding concentrator;
- At least one solar (10) laser device, as a solar converter, where the laser device (10) is adapted to directly receive concentrated radiation from the concentrators in the collectors (11) and transform this radiation into laser radiation; and
- A receiver (1) adapted to receive radiation from the lightguides (8) through second ends (not shown), opposite the first ends, and use said radiation to heat a heat transfer fluid (not shown) or transmit it to a photoelectric sensor (not shown) and/or a solar reactor (21) adapted to obtain solar fuel.

The divergence characteristics explained earlier for the laser beam make it possible to target the laser beam directly to the receiver through simple plane mirrors (26) (see Figures 2 and 6) without appreciable loss of power.

SECOND PREFERRED EMBODIMENT

For cases where the distance between the receiver and the laser is not so limited, the invention further incorporates flexible lightguides (8) which transmit light from the laser devices to the receiver, as shown in Figure 3.

THIRD PREFERRED EMBODIMENT

In a third recommended model of the invention, shown schematically in Figures 4 and 5, in the collector concentrators (11), at least one cell photovoltaic (18) is present in place to transform the concentrated radiation into electricity (I). The photovoltaic cell (18) is transparent for those solar wavelengths that cannot be transformed into electric energy (I). Most preferably, multijunction HCPV photovoltaic cells (18) are used, though single-junction, organic or inorganic photovoltaic cells (18) may also be utilised.

The photovoltaic cells (18) are interspersed among the collectors (11) and the laser device (10), such that the radiation from the collectors that is not transformed by the photovoltaic cell (18) will reach the laser device (10) after passing through this photovoltaic cell (18). The laser device (10) will transform these wavelengths into one or more wavelength of the right characteristics to be transmitted through lightguides (8) over long distances to a receiver (1), which may be a thermosolar or photovoltaic receiver (another photovoltaic cell, not shown, for instance).

The use of photovoltaic cells (18) is compatible with either of the two models discussed above.

Consistent with either of models two and three above, lightguides (8) of high numerical aperture are preferably selected. More preferably still, a numerical aperture near 0.9, where the numerical aperture is as compatible as possible with the opening of the photovoltaic cell of the solar laser and solar collectors.

To obtain greater irradiance, the plant includes lenses (14) for combining (multiplexing) the radiation of at least one set of lightguides (8) into at least one combined guide (15). Similarly in the same way, combined guides (15) may also be combined with one another, and so on.

For using thermosolar type receptors (1), lightguides (8) whose first ends are arranged in adjacent locations do not affect adjacent locations of the thermosolar receptor (1), to offset the effects of some collectors (11) being possibly in the shade, and thus produce a more uniform incidence on the receiver. Typically, the solar collectors (11) are grouped into blocks (17). Therefore, what has just been explained can be implemented in at least one of the cases of the following non-exhaustive list:

- Lightguides (8) are routed directly to the thermosolar receiver (1) so that the lightguides (8) of a single block (17) do not all go to the same receiver area (1), but in each receiver area (1), the lightguides (8) adjacent to those from the same block (17) are coming from blocks (17) located elsewhere;
- The lightguides (8) of a single block (17) are multiplexed into combined guides (15), and these combined guides (15) for adjacent blocks (17) are in turn routed to nonadjacent receiver areas (1); and
- The combined guides (15) combine lightguides (8) from different blocks (17).

While this invention is applicable to any type of receiver (1) compatible with the use of concentrator collectors (11) and, where appropriate, lightguides (8), in the case of thermosolar receivers, absorber tube receivers (1) (not shown) in a vertical position are preferred, through which a heat transfer fluid is circulated.

Thus, the tubes of the receiver (1) can be arranged in one or several rows, preferably in more than one row overlapping the tubes so the radiation will always find one of the tubes. Additionally, the tubes may or may not be enclosed in transparent containers under vacuum. The containers may be either individual type for each absorber tube, or there may be one or more containers that are common to a number of absorber tubes. Moreover, the tubes may be equipped with antireflection coatings.

The lightguides (8) are preferably made to route radiation to the absorber tubes normally to the surface of the absorber tubes, from two opposing directions to avoid thermal stress in said absorber tubes.

The invention can work with any type of laser device (10), although a longitudinal pumping laser device (10) is preferred.

The invention plant also includes a storage means (16) for accumulating energy, for instance, in the case that solar irradiance exceeds the nominal value, or so that stored energy can be utilised in periods of low (or no) radiation, such as under clouds, nighttime, and so on.

The invention plant may further include transformation means (not shown) for transforming thermal energy from the receiver into electrical energy such as a steam turbine, a gas turbine, a Stirling engine, microturbine, or an AMTEC element.

The storage means (16) are related to the transformation means, so that the storage means may be selected from:

- Electric accumulators for accumulating at least part of the electrical energy produced in a photovoltaic type receiver (1);
- Tanks of hot air/gas, if the receiver is a thermosolar receiver adapted to heat a heat transfer fluid and the transformation media are a gas turbine;
- Tanks of compressed saturated steam, if the receiver (1) is the thermosolar type adapted to heat a heat transfer fluid and the transformation means are steam turbines; and
- Tanks of salts at high temperature, if the receiver (1) is the thermosolar type adapted to heat a heat transfer fluid that is a salt to be used in a steam turbine based on a Rankine cycle.

As seen in Figure 5, the storage means (16) may store energy from the guides (8, 15) or receiver (1), and the solar reactor (21) may receive energy from the guides (8, 15). Additionally, pipes (25) are arranged to transport the heat transfer fluid from the receiver (1) to the transformation means or to somewhere else for use (not shown). Pipes (25) are also arranged to transport heat transfer fluid back and forth between the receiver (1) to the storage means (16).

## Claims

1. Solar plant, **characterised in that** it comprises:

   - At least one solar collector (11) equipped with a concentrator, said solar collector (11) adapted to collect solar radiation and concentrate that solar radiation in the concentrator;
   - At least one solar laser device (10), as a solar converter, where the laser device (10) is adapted to receive, directly or indirectly, concentrated radiation from the concentrators in the collectors (11) and transform said concentrated radiation into laser radiation; and
   - A solar receiver (1) and/or reactor (21) adapted to receive radiation from laser devices (10) and transform it into another form of energy, where the receiver (1) is adapted to use such radiation to heat a heat transfer medium (not shown) or to transmit the radiation to a photoelectric sensor (not shown), and the solar reactor (21) is adapted to obtain solar fuel.

2. Solar power plant according to claim 1, **characterised in that** it further comprises separate plane mirrors (26) adapted to direct light from the laser devices (10) via reflection towards the solar reactor (21) and/or towards the receiver (1).

3. Solar power plant according to claim 1, **characterised by** further comprising separate flexible lightguides (8), adapted so that they collect from one end the radiation emitted by the laser devices (10) and transport said radiation towards the solar reactor (21) and/or towards the receiver (1).

4. Solar power plant according to any of claims 1 to 3, **characterised by** further comprising at least one photovoltaic cell (18) inserted between the collectors (11) and the laser devices (10), where the photovoltaic cell (18) is adapted to receive a portion of radiation concentrated in the concentrators and transform it into electricity, and is transparent to the part that cannot be transformed, allowing the untransformed portion to reach the laser devices (10).

5. Solar power plant according to claim 4, **characterised in that** the photovoltaic cells (18) are HCPV cells.

6. Solar power plant according to claim 5, **characterised in that** the photovoltaic cells (18) are multi-junction type HCPV cells.

7. Solar plant according to any of claims 1 to 6, **characterised in that** the receiver (1) is selected from a list consisting of:

   - thermosolar receiver;
   - photovoltaic receiver.

8. Solar plant according to any of claims 1 to 7, **characterised in that** the solar collectors (11) are selected from a list consisting of:

   - parabolic type disc collectors,
   - lens type Fresnel collectors,
   - advanced collectors, developed based on non-imaging optics.

9. Solar power plant according to any of claims 1 to 8, **characterised by** further comprising at least one dual-axis tracking device to orient the collectors.

10. Solar power plant according to claim 9, **characterised in that** each solar collector is linked to its own individual tracking device.

11. Solar power plant according to claim 9, **characterised by** comprising at least one tracking device linked to multiple collectors (11).

12. Solar plant according to any of claims 3 to 11, **characterised in that** the lightguides (8) are selected from a list consisting of:

   - traditional fibre optic guides,
   - PCF type guides,
   - liquid lightguides.

13. Solar plant according to claim 12, **characterised in that** the conventional fibre optic lightguides (8) are selected from a list consisting of:

   - MCVD type guides, and
   - OVD type guides,

14. Solar plant according to claim 12, **characterised in that** the PCF type lightguides (8) are selected from a list consisting of:

   - IGF type guides,
   - PBF type guides.

15. Solar power plant according to claim 12, **characterised in that** the PCF type lightguides (8) are doped with $P_2O_5$.

16. Solar plant according to any of claims 13 to 15, **characterised in that** the lightguides (8) are designed with materials selected from a list consisting of:

   - fused silica lightguides ;
   - ZBLAN glass lightguides; and
   - GaLaS glass lightguides;

17. Solar power plant according to any preceding claim 13 to 15, **characterised in that** it further comprises lens (14), each of which lens (14) is adapted to multiplex the radiation into at least one combined guide (15).

18. Solar power plant according to claim 7, **characterised in that** the receiver (1) is of thermosolar type, where the radiation incident on adjacent regions of the receiver (1) comes from guides (8, 15) located in nonadjacent areas of the collectors (11).

19. Solar plant according to claim 18, **characterised in that** the lightguides (8) are routed directly to the receiver (1), so that not all lightguides (8) of a single area of collectors (11) are routed to the same area of the receiver (1), but in every area of the receiver (1), the lightguides (8) adjacent to those from one area of collectors (11) come from collector areas (11) located elsewhere.

20. Solar power plant according to claims 18 and 19, **characterised in that** the lightguides (8) of a collector area (11) are multiplexed so that the combined guides (15) adjacent in the receiver (1) combine lightguides (8) that come from collector areas (11) located elsewhere.

21. Solar power plant according to claims 18 and 19, **characterised in that** the combined guides (15) combine lightguides (8) from different areas of collectors (11).

22. Solar power plant according to any one of the preceding claims, **characterised in that** the laser device (10) is longitudinal pumping.

23. Solar power plant according to any of the preceding claims, **characterised by** further incorporating a storage means (16) for storing part of the transformed solar radiation.

24. Solar plant according to claim 23, **characterised in that** the storage means (16) comprise at least one of the following list:

- electric accumulators;
- tanks of hot air/gas;
- tanks of saturated compressed steam; and
- tanks of salt type heat transfer fluid at high temperature.

25. Solar power plant according to any of the preceding claims, **characterised by** further comprising transformation means for transforming the thermal energy of the receiver into electric energy.

26. Solar plant according to claim 25, **characterised in that** the transformation means are selected from a list consisting of:

- steam turbine;
- gas turbine;
- Stirling engine
- Micro turbine; and
- AMTEC element.

27. Solar power plant according to claim 1, **characterised in that** the solar reactor (21) is adapted to obtain at least one solar fuel selected from a list consisting of:

- hydrogen, directly from water at a temperature not exceeding 2000 °C, and
- ammonia, from nitrogen and hydrogen.

28. Solar power plant according to claim 27, **characterised in that** the solar reactor (21) is adapted to produce hydrogen using zinc.

29. Solar power plant according to claim 27, **characterised in that** the solar reactor (21) is adapted to produce hydrogen using iodine sulfur processes.

FIG. 1a

FIG. 1b

FIG. 2

FIG. 3

FIG. 4

FIG. 5

FIG. 6

## INTERNATIONAL SEARCH REPORT

| International application No. |
| --- |
| PCT/ES2012/070480 |

### A. CLASSIFICATION OF SUBJECT MATTER

See extra sheet

According to International Patent Classification (IPC) or to both national classification and IPC

### B. FIELDS SEARCHED

Minimum documentation searched (classification system followed by classification symbols)
H01S, H01L, F24J, G02B

Documentation searched other than minimum documentation to the extent that such documents are included in the fields searched

Electronic data base consulted during the international search (name of data base and, where practicable, search terms used)

EPODOC, INVENES

### C. DOCUMENTS CONSIDERED TO BE RELEVANT

| Category* | Citation of document, with indication, where appropriate, of the relevant passages | Relevant to claim No. |
| --- | --- | --- |
| X | CN 201018430 Y (ZHIQIANG WAN ) 06/02/2008, abstract EPODOC, abstract WPI, figure. | 1, 7-11, 22-29 |
| Y | | 2-6, 12-16 |
| A | | 17-21 |
| X | CN 101237196 A (ZHIQIANG WAN ) 06/08/2008, abstract EPODOC, abstract WPI, figure. | 1, 7-11, 22-29 |
| Y | | 2-6, 12-16 |
| A | | 17-21 |
| Y | ES 2236499 T3 (UNIV GLASGOW ) 16/07/2005, figure 1, column 2, lines 10-44, column 3, lines 22-39 | 2, 3 |
| A | | 1, 4-29 |

☒ Further documents are listed in the continuation of Box C.   ☒ See patent family annex.

| * Special categories of cited documents: | "T" | later document published after the international filing date or priority date and not in conflict with the application but cited to understand the principle or theory underlying the invention |
| --- | --- | --- |
| "A" document defining the general state of the art which is not considered to be of particular relevance. | | |
| "E" earlier document but published on or after the international filing date | | |
| "L" document which may throw doubts on priority claim(s) or which is cited to establish the publication date of another citation or other special reason (as specified) | "X" | document of particular relevance; the claimed invention cannot be considered novel or cannot be considered to involve an inventive step when the document is taken alone |
| "O" document referring to an oral disclosure use, exhibition, or other means. | "Y" | document of particular relevance; the claimed invention cannot be considered to involve an inventive step when the document is combined with one or more other documents , such combination being obvious to a person skilled in the art |
| "P" document published prior to the international filing date but later than the priority date claimed | "&" | document member of the same patent family |

| Date of the actual completion of the international search | Date of mailing of the international search report |
| --- | --- |
| 11/10/2012 | **(16/10/2012)** |

| Name and mailing address of the ISA/ | Authorized officer |
| --- | --- |
| OFICINA ESPAÑOLA DE PATENTES Y MARCAS<br>Paseo de la Castellana, 75 - 28071 Madrid (España)<br>Facsimile No.: 91 349 53 04 | A. López Ramiro<br><br>Telephone No. 91 3495322 |

Form PCT/ISA/210 (second sheet) (July 2009)

## INTERNATIONAL SEARCH REPORT

| | International application No. |
|---|---|
| | PCT/ES2012/070480 |

| C (continuation). | DOCUMENTS CONSIDERED TO BE RELEVANT | |
|---|---|---|
| Category * | Citation of documents, with indication, where appropriate, of the relevant passages | Relevant to claim No. |
| Y | US 4281294 A (VOLKIN HOWARD C ) 28/07/1981, abstract, figures 1, 4, column 1, lines 32-56, column 2, lines 58-68, column 3, line 51 a column 4 line 58. | 4-6, 12-16 |
| A | | 1-3, 7-11, 17-29 |
| A | RU 2087062 C1 (GOLGER ALEKSANDR L ET AL.) 10/08/1997, abstract EPODOC, abstract WPI, figure. | 1-29 |
| A | 10/02/2005, Tese of Édison Trípole2004, Documento retrieved from internet, "Potencial of utilizaçao of fibras ópticas no desenvolvimento of concentradores solares", <URL: http://www.ufv.br/dea/ambiagro/arquivos/ Tese%20de%20%C3%89dison%20Tr%C3%ADpole2004.pdf >, [retrieved on 04/09/2012] 10/02/2005; pages 8-19, 29-39. | 1-29 |
| A | US 4001704 A (DANIELMEYER HANS-GUNTER ET AL.) 04/01/1977, the whole document | 1-29 |

Form PCT/ISA/210 (continuation of second sheet) (July 2009)

## INTERNATIONAL SEARCH REPORT

Information on patent family members

| | International application No. |
|---|---|
| | PCT/ES2012/070480 |

| Patent document cited in the search report | Publication date | Patent family member(s) | Publication date |
|---|---|---|---|
| CN201018430 | 06.02.2008 | NONE | |
| CN101237196 A | 06.08.2008 | NONE | |
| ES2236499 T | 16.07.2005 | GB2371405 AB | 24.07.2002 |
| | | US2002097762 A | 25.07.2002 |
| | | US6717971 B | 06.04.2004 |
| | | WO02060023 A | 01.08.2002 |
| | | EP1356553 AB | 29.10.2003 |
| | | EP20020716151 | 23.01.2002 |
| | | CN1488183 A | 07.04.2004 |
| | | CN1224147 C | 19.10.2005 |
| | | JP2004520710 A | 08.07.2004 |
| | | AT282901 T | 15.12.2004 |
| | | DE60201974 T | 15.12.2005 |
| US4281294 A | 28.07.1981 | NONE | |
| RU2087062 C | 10.08.1997 | NONE | |
| US4001704 A | 04.01.1977 | BE827113 A | 16.07.1975 |
| | | NL7503472 A | 29.09.1975 |
| | | DE2414209 A | 09.10.1975 |
| | | FR2266339 A | 24.10.1975 |
| | | JP50134396 A | 24.10.1975 |
| | | GB1485912 A | 14.09.1977 |
| | | IT1034521 B | 10.10.1979 |

Form PCT/ISA/210 (patent family annex) (July 2009)

## INTERNATIONAL SEARCH REPORT

International application No.

PCT/ES2012/070480

CLASSIFICATION OF SUBJECT MATTER

*H01S5/026* (2006.01)
*H01L31/04* (2006.01)
*F24J2/07* (2006.01)
*G02B6/42* (2006.01)

# EP 2 731 210 A1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **D. FEUERMANN ; J. M. GORDON ; M HULEIHIL.** *Solar fibre-optic mini-dish concentrators: First experimental results and field experience,* April 2002